# EUROPEAN PATENT SPECIFICATION

(11) **EP 3 979 439 B1**
(45) Date of publication and mention of the grant of the patent: **03.04.2024**
(21) Application number: 19931295.0
(22) Date of filing: 28.05.2019
(51) Int. Cl.: H01S 5/028, H01S 5/22, H01S 5/125

(54) **LASER DIODE AND MANUFACTURING METHOD THEREFOR**
LASERDIODE UND HERSTELLUNGSVERFAHREN DAFÜR
DIODE LASER ET SON PROCÉDÉ DE FABRICATION

(43) Date of publication of application: 06.04.2022
(73) Proprietor: Xiamen San'an Optoelectronics Co., Ltd., Xoa,em.Fikoam 361100 (CN)
(72) Inventor: ZHONG, Zhibai, Xiamen, Fujian 361009 (CN); LEE, Chia-en, Xiamen, Fujian 361009 (CN); CHUO, Chang-cheng, Xiamen, Fujian 361009 (CN); HSU, Chen-ke, Xiamen, Fujian 361009 (CN); KANG, Junyong, Xiamen, Fujian 361009 (CN)
(74) Representative: Bals & Vogel Patentanwälte PartGmbB
(86) International application number: PCT/CN2019/088883
(87) International publication number: WO 2020/237512

(56) References cited:
- EP-A1- 3 462 552
- WO-A1-2014/061328
- CN-A- 107 851 952
- DE-A1- 10 323 860
- DE-A1-102014 221 915
- JP-A- 2011 035 315
- US-A1- 2004 233 950
- US-A1- 2008 198 886
- US-A1- 2009 275 159

## Description

### TECHNICAL FIELD

The invention relates to the field of semiconductor light-emitting diodes, in particular to a laser diode and a manufacturing method thereof.

### BACKGROUND

GaN-based light-emitting diodes and laser diodes have been widely researched and commercially applied, especially in laser display and laser projection, such as GaN blue and green laser diodes (LD for short). The main structure of the laser diode includes an edge-emitting ridge waveguide structure. Utilization of a side-emitting ridge waveguide structure requires to plate distributed Bragg reflection (DBR) mirrors at both ends of the Bar to make a Fabry-Perot (FP) cavity to realize resonance. Conventional cavity surfaces are all right-angled shapes, resulting in poor coverage of DBR at the corners, and the there is a high stress in the DBR, making it easy to crack. Meanwhile, the laterally plated DBR may affect the eutectic of LD, thereby affecting the electrical performance.

Reference D1 (WO2014061328A1) discloses a group-III nitride semiconductor featuring a laser resonator that can aid in the reduction of disturbance caused by return light.

Reference D2 (DE10323860A1) discloses a semiconductor laser composed of a radiationally active layer parallel to a resonating axis.

### SUMMARY

One aspect of the present invention provides a laser diode, including a substrate and a stacked layer on the substrate. The stacked layer includes an N-type layer, an active layer, a P-type layer with a ridge-shaped strip on a surface thereof, and a laterally plated DBR cladding layer. An end surface of the ridge-shaped strip along a length direction of the ridge-shaped strip is a first inclined surface which is inclined with respect to both a normal direction of a lower surface of the ridge-shaped strip and an emission end surface of the laser diode, and a contact surface of the ridge-shaped strip in contact with the DBR cladding layer includes the first inclined surface.

Optionally, an angle between the first inclined surface and a normal direction of a lower surface of the ridge-shaped strip is greater than 0 degrees and less than or equal to 60 degrees.

Optionally, an end surface of the substrate includes a second inclined surface along the length direction of the ridge-shaped strip, which is inclined with respect to both a normal direction of an upper surface of the substrate and the emission end surface of the laser diode, and a contact surface of the substrate in contact with the DBR cladding layer includes the second inclined surface.

Optionally, an angle between the second inclined surface and a normal direction of an upper surface of the substrate is greater than 0 degrees and less than or equal to 60 degrees.

Optionally, the first inclined surface is located on the P-type layer.

Optionally, the N-type layer includes a metal layer for conduction.

Optionally, the P-type layer includes a metal layer for conduction.

Optionally, the P-type layer further includes an upper waveguide layer.

Another aspect of the present invention provides a method for manufacturing a laser diode, characterized in that the method includes the steps:
epitaxially growing an N-type layer, an active layer and a P-type layer in sequence on a substrate, and making a ridge-shaped strip on the P-type layer;
splitting the ridge-shaped strip in a direction perpendicular to a length of the ridge-shaped strip to obtain an end surface of the ridge-shaped strip which is a first inclined surface inclined with respect to both a normal direction of a lower surface of the ridge-shaped strip and an emission end surface of the laser diode;
growing a laterally plated DBR cladding layer, and a contact surface of the ridge-shaped strip in contact with the DBR cladding layer including the first inclined surface.

Optionally, after the step of obtaining the first inclined surface, the method further includes: splitting the substrate in the direction perpendicular to the length of the ridge-shaped strip to obtain an end surface of the substrate which is a second inclined surface, and a contact surface of the substrate in contact with the DBR cladding layer including the second inclined surface.

Optionally, the step of splitting the ridge-shaped strip in the direction perpendicular to the length of the ridge-shaped strip includes: making a V-shaped groove, an arc-shaped groove, an open inverted trapezoidal groove, or a combination thereof on the ridge-shaped strip and splitting the ridge-shaped strip vertically along the middle of the groove to form the end surface of the ridge-shaped strip.

Optionally, the step of splitting the substrate in the direction perpendicular to the length of the ridge-shaped strip includes: making a V-shaped groove, an arc-shaped groove, an open inverted trapezoidal groove, or a combination thereof on the substrate and splitting the substrate vertically along the middle of the groove to form the end surface of the substrate.

Optionally, a length direction of the V-shaped groove, the arc-shaped groove, the open inverted trapezoidal groove or the combination thereof is perpendicular to the length of the ridge-shaped strip.

### BRIEF DESCRIPTION OF THE DRAWINGS

Fig. 1 is diagram of a structure of a laser diode according to an embodiment of the present invention;
Fig. 2 is a schematic diagram of a structure of a single-sided wedge-shaped laser diode according to an embodiment of the present invention;
Fig. 3 is a schematic diagram of a structure of a double-sided wedge-shaped laser diode according to an embodiment of the present invention;
Fig. 4 shows a schematic flow chart of the manufacturing method of the laser diode according to an embodiment of the present invention;
Fig. 5 is a schematic diagram showing the positional relationship between the V-shaped groove and the ridge-shaped strip according to an embodiment of the present invention;
FIG. 6 is a schematic diagram of a structure of a partially-oblique, double-sided, wedge-shaped laser diode according to an embodiment of the present invention.

### Description of reference numbers

**Table I**

| Reference No. | Name | Reference No. | Name |
|---|---|---|---|
| 1 | V-shaped groove, an arc-shaped groove or an open inverted trapezoidal groove | 2 | Ridge-shaped strip |
| 3 | Substrate | 4 | N-type layer |
| 41 | N-type metal layer | 5 | MQW active layer |
| 6 | P-type layer | 61 | Upper waveguide layer |
| 62 | P-type metal layer | 7 | First inclined surface |
| 8 | DBR cladding layer | 9 | Second inclined surface |

### DETAILED DESCRIPTION OF THE EMBODIMENTS

The following specific embodiments illustrate the implementation of the present invention. Those familiar with this technology can easily understand the other advantages and effects of the present invention from the content disclosed in this specification.

It should be noted that structures, ratios, sizes, and the like shown in the drawings of the present specification are only used for cooperation with the disclosure of the specification so as to be understood and read by those familiar with the art, rather than being used to limit the conditions under which the present invention can be implemented. Thus, they have no substantive technical significance, and any structural modifications, changes of ratio relationships or size adjustment still fall within the scope that can be covered by the technical contents disclosed in the present invention without affecting the effects that can be produced by the present invention and the objects that can be achieved. Terms such as "upper", "lower", "front side", "back side", "middle" and "one (a, an)", and the like referred to in the present specification are merely for clarity of description rather than being intended to limit the implementable scope of the present invention, and changes or alterations of relative relationships thereof without substantial technical changes should also be considered as being within the implementable scope of the present invention.

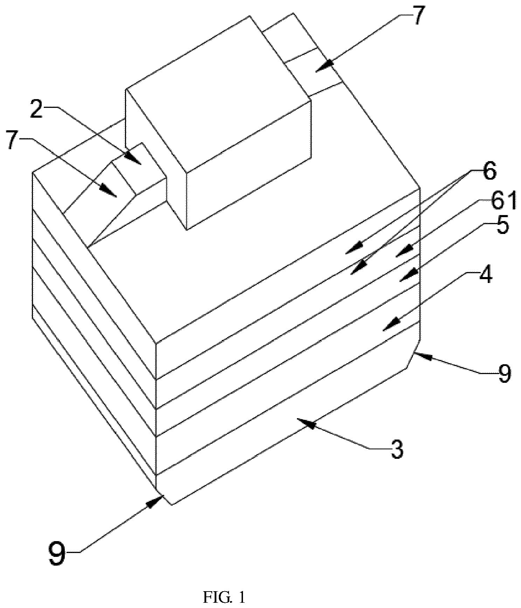

As shown in FIGS. 1-2, an embodiment of the present invention provides a laser diode, including a substrate 3, and a stacked layer on the substrate. The stacked layer includes an N-type layer 4, a multi-quantum wells (MQW) active layer 5, a P-type layer 6 with a ridge-shaped strip 2 on a surface thereof, and a DBR cladding layer 8. An end surface of the ridge-shaped strip is a first inclined surface 7, and a contact surface of the ridge-shaped strip in contact with the DBR cladding layer includes the first inclined surface.

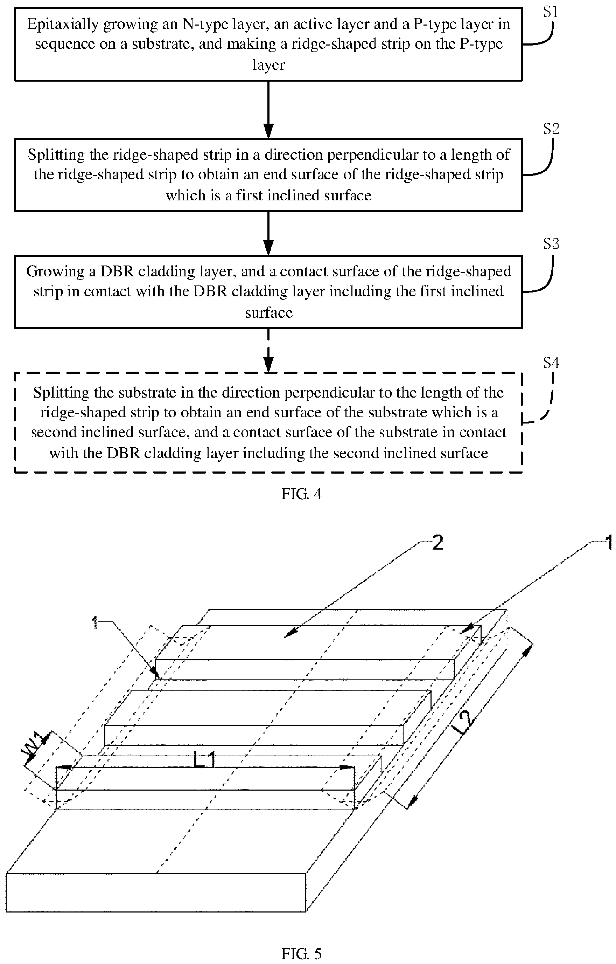

As shown in Figure 5, the end surface is at each end of the ridge-shaped strip along a length (L1) direction. The first inclined surface 7 is parallel to a width side W1 of the ridge-shaped strip 2, or the width side of the ridge-shaped strip is located on the first inclined surface. The contact surface includes the first inclined surface. The laser diode has a single-sided wedge-shaped structure. The single-side structure solves the problem of poor coverage of the corner DBR, high stress and easy breakage caused by a right-angled shape of an existing cavity surface, as well as the problem that a laterally plated DBR may affect the eutectic of the LD and the electrical performance of the LD.

In an embodiment, an angle between the first inclined surface and a normal direction of a lower surface of the ridge-shaped strip is greater than 0 degrees and less than or equal to 60 degrees. This angle range can ensure that the DBR is well covered on the ridge-shaped strip and is not easy to fall off.

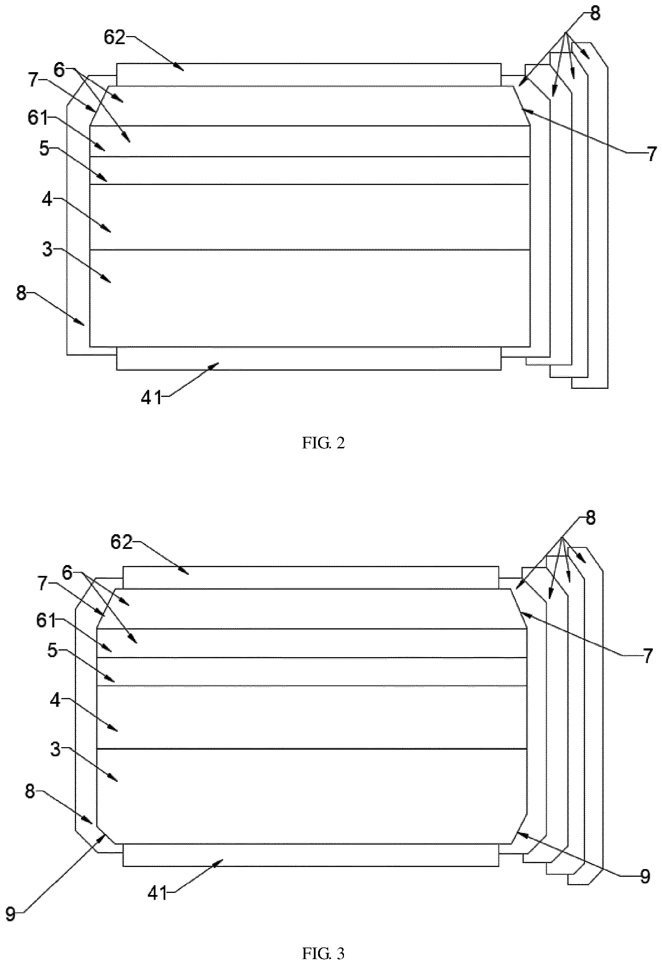

As shown in FIGS. 1 and 3, in an embodiment, an end surface of the substrate includes a second inclined surface, and a contact surface of substrate in contact with the DBR cladding layer includes the second inclined surface 9. The end surface is located on the back surface of the substrate and at each end of the substrate along the length of the ridge-shaped strip. The back side mentioned here is relative to the front side, and the front side is the side used for the epitaxial growth of the stacked layer. This laser diode has a double-sided wedge-shaped structure. The first inclined surface and the second inclined surface form a double-sided inclined surfaces structure, so that the DBR cladding layer has better coverage on the substrate and is not easy to fall off, thereby ensuring the good electrical performance of the LD.

In an embodiment, an angle between the second inclined surface and a normal direction of an upper surface of the substrate is greater than 0 degrees and less than or equal to 60 degrees. This angle range can ensure that the DBR is well covered on the substrate and is not easy to fall off.

In an embodiment, the first inclined surface is located on the P-type layer. In addition, during the manufacturing of the first inclined surface, the first inclined surface does not extend into the MQW active layer.

In an embodiment, the N-type layer includes an N-type metal layer 41. The N-type metal layer is used for connection of the N-type layer and conduction.

In an embodiment, the P-type layer includes a P-type metal layer 62. The P-type metal layer is used for connection of the P-type layer and conduction.

In an embodiment, the P-type layer further includes an upper waveguide layer 61, which may be of P-InGaN. The first inclined surface is formed by forming a V-shaped groove, an arc-shaped groove or an open inverted trapezoidal groove 1 and then splitting. The depth of the V-shaped groove, the arc-shaped groove or the open inverted trapezoidal groove does not exceed the upper waveguide layer, which ensures that the splitting will not be excessive, and the first inclined surface is limited on the P-type layer and does not extend into the active layer.

As shown in FIG. 4, an embodiment of the present invention provides a method for manufacturing a laser diode, which includes the steps:
51, epitaxially growing an N-type layer, an MQW active layer and a P-type layer on the substrate in sequence, and making a ridge-shaped strip on the P-type layer;
S2, splitting the ridge-shaped strip in a direction perpendicular to a length of the ridge-shaped strip to obtain an end surface of the ridge-shaped strip which is a first inclined surface;
S3, growing a DBR cladding layer, and a contact surface of the ridge-shaped strip in contact with the DBR cladding layer includes the first inclined surface.

The contact surface includes the first inclined surface, which directly solves the problem of poor coverage of the corner DBR due to the right-angled shape of a cavity surface, high stress and easy breakage, as well as the problem that a laterally plated DBR may affect the eutectic of the LD and electrical performance of the LD.

In an embodiment, the angle between the first inclined surface and a normal direction of a lower surface of the ridge-shaped strip is greater than 0 degrees and less than or equal to 60 degrees. This angle range can ensure that the DBR is well covered on the substrate and is not easy to fall off.

In an embodiment, after the step of obtaining the first inclined surface, the method further includes:
S4, splitting the substrate in the direction perpendicular to the length of the ridge-shaped strip to obtain an end surface of the substrate which is a second inclined surface, and a contact surface of the substrate in contact with the DBR cladding layer including the second inclined surface.

Through the above steps, a double-sided wedge-shaped laser diode can be obtained. The first inclined surface and the second inclined surface form a double-sided inclined surface structure, so that the DBR cladding layer has better coverage on the substrate and is not easy to fall off, thereby ensuring good electrical performance of the LD.

In an embodiment, the angle between the second inclined surface and a normal direction of an upper surface of the substrate is greater than 0 degrees and less than or equal to 60 degrees. This angle range can ensure that the DBR is well covered on the substrate and is not easy to fall off.

As shown in FIG. 5, in an embodiment, the step of splitting the ridge-shaped strip along a direction perpendicular to the length of the ridge-shaped strip includes making a V-shaped groove, an arc-shaped groove, an open inverted trapezoidal groove, or a combination thereof on the ridge-shaped strip and splitting the ridge-shaped strip vertically along the middle of the groove to form the end surface of the ridge-shaped strip.

In an embodiment, the step of splitting the substrate in the direction perpendicular to the length of the ridge-shaped strip includes making a V-shaped groove, an arc-shaped groove or an open inverted trapezoidal groove or a combination thereof on the substrate, and splitting the substrate vertically along the middle of the groove to form the end surface of the substrate.

The length direction of the groove body is perpendicular to the length of the ridge-shaped strip, that is, L2 is perpendicular to L1. The V-shaped groove, the arc-shaped groove, the open inverted trapezoidal groove or the combination thereof can be obtained by a combination of a yellow light process and an ICP (Inductive Coupled Plasma) etching process or other methods.

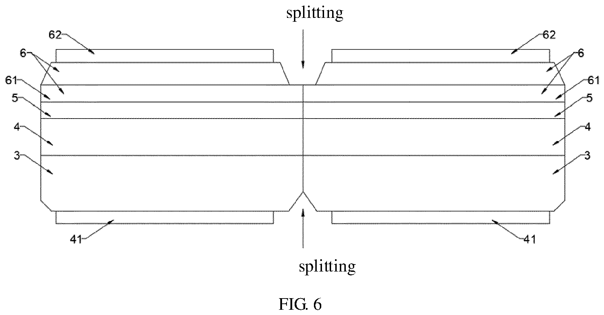

As shown in FIG. 6, in an embodiment, the ridge-shaped strip and the substrate are split using different grooves to obtain a partially oblique, double-sided, and wedge-shaped laser diode. Specifically, for example, an open inverted trapezoidal groove is made on the ridge-shaped strip, and a V-shaped groove is made on the substrate, and then vertically split along the middle of the grooves to form inclined end surfaces. This can further expand the practical application of the method of the present invention. The above-mentioned technical solutions provided by the embodiments of the present invention not only make it easier to manufacture a spacer bar for the DBR of the LD, but also can effectively solve the problem of poor DBR coverage caused by the conventional vertical cavity surface, high stress and easy breakage, and the problem of poor electrical performance of the LD due to the fact that a laterally plated DBR may affect the eutectic of LD. In addition, according to the conventional solutions, in the high current test, the contact layer near the end surface has a high resistance and poor current spreading. In contrast, according the embodiments of the present invention, a part of contact surface where the end surface is etched off improves the coverage of the DBR at the end surface, reduces the current density near the contact surface, and improves the LD's ability to resist catastrophic optical damage.

The above embodiments merely illustratively describe the principles of the present invention and effects thereof, rather than limiting the present invention. Anyone familiar with this technology can modify or change the above embodiments without departing from the scope of the present invention.

## Claims

1. A laser diode, comprising a substrate (3) and a stacked layer on the substrate (3), the stacked layer comprising an N-type layer (4), an active layer (5), a P-type layer (6) with a ridge-shaped strip (2) on a surface thereof, and a laterally plated DBR cladding layer (8), **characterized in that** an end surface of the ridge-shaped strip (2) along a length direction of the ridge-shaped strip (2) is a first inclined surface (7) which is inclined with respect to both a normal direction of a lower surface of the ridge-shaped strip (2) and an emission end surface of the laser diode, and a contact surface of the ridge-shaped strip (2) in contact with the DBR cladding layer (8) comprises the first inclined surface (7).

2. The laser diode of claim 1, **characterized in that** an angle between the first inclined surface (7) and a normal direction of a lower surface of the ridge-shaped strip (2) is greater than 0 degrees and less than or equal to 60 degrees.

3. The laser diode of claim 1, **characterized in that** an end surface of the substrate (3) comprises a second inclined surface (9) along the length direction of the ridge-shaped strip (2), which is inclined with respect to both a normal direction of an upper surface of the substrate (3) and the emission end surface of the laser diode, and a contact surface of the substrate (3) in contact with the DBR cladding layer (8) comprises the second inclined surface (9).

4. The laser diode of claim 3, **characterized in that** an angle between the second inclined surface (9) and a normal direction of an upper surface of the substrate (3) is greater than 0 degrees and less than or equal to 60 degrees.

5. The laser diode of claim 3, **characterized in that** the contact surface of the substrate (3) in contact with the DBR cladding layer (8) further comprises a side surface of the substrate (3), and the second inclined surface (9) connects the side surface of substrate (3) and a lower surface of the substrate (3).

6. The laser diode of claim 1, **characterized in that** the first inclined surface (7) is located on the P-type layer (6).

7. The laser diode of claim 1, **characterized in that** the N-type layer (4) comprises a metal layer (41) for conduction.

8. The laser diode of claim 1, **characterized in that** the P-type layer (6) comprises a metal layer (62) for conduction.

9. The laser diode of claim 1, **characterized in that** the P-type layer (6) further comprises an upper waveguide layer (61).

10. A method for manufacturing a laser diode comprising epitaxially growing an N-type layer (4), an active layer (5) and a P-type layer (6) in sequence on a substrate (3), and making a ridge-shaped strip (2) on the P-type layer (6), **characterized in that** the method further comprises the steps:
splitting the ridge-shaped strip (2) in a direction perpendicular to a length of the ridge-shaped strip (2) to obtain an end surface of the ridge-shaped strip (2) which is a first inclined surface (7) inclined with respect to both a normal direction of a lower surface of the ridge-shaped strip (2) and an emission end surface of the laser diode;
growing a laterally plated DBR cladding layer (8), and a contact surface of the ridge-shaped strip (2) in contact with the DBR cladding layer (8) comprising the first inclined surface (7).

11. The method of claim 10, **characterized in that**, after the step of obtaining the first inclined surface (7), the method further comprises:
splitting the substrate (3) in the direction perpendicular to the length of the ridge-shaped strip (2) to obtain an end surface of the substrate (3) which is a second inclined surface (9), and a contact surface of the substrate (3) in contact with the DBR cladding layer (8) comprising the second inclined surface (9).

12. The method of claim 10, **characterized in that** the step of splitting the ridge-shaped strip (2) in the direction perpendicular to the length of the ridge-shaped strip (2) comprises:
making a V-shaped groove, an arc-shaped groove, an open inverted trapezoidal groove, or a combination thereof on the ridge-shaped strip (2) and splitting the ridge-shaped strip (2) vertically along the middle of the groove to form the end surface of the ridge-shaped strip (2).

13. The method of claim 11, **characterized in that** the step of splitting the substrate (3) in the direction perpendicular to the length of the ridge-shaped strip (2) comprises:
making a V-shaped groove, an arc-shaped groove, an open inverted trapezoidal groove, or a combination thereof on the substrate (3) and splitting the substrate (3) vertically along the middle of the groove to form the end surface of the substrate (3).

14. The method of claim 12 or 13, **characterized in that** a length direction of the V-shaped groove, the arc-shaped groove, the open inverted trapezoidal groove or the combination thereof is perpendicular to the length of the ridge-shaped strip (2).

15. The method of claim 11, **characterized in that** the ridge-shaped strip (2) and the substrate (3) are split respectively using different grooves in shape.

## Patentansprüche

1. Laserdiode mit einem Substrat (3) und einer gestapelten Schicht auf dem Substrat (3), wobei die gestapelte Schicht eine N-Typ-Schicht (4), eine aktive Schicht (5), eine P-Typ-Schicht (6) mit einem stegförmigen Streifen (2) auf einer Oberfläche davon und eine seitlich plattierte DBR-Mantelschicht (8) umfasst, **dadurch gekennzeichnet, dass** eine Endfläche des stegförmigen Streifens (2) entlang einer Längsrichtung des stegförmigen Streifens (2) eine erste geneigte Fläche (7) ist, die sowohl in Bezug auf eine normale Richtung einer unteren Fläche des stegförmigen Streifens (2) als auch in Bezug auf eine Emissionsendfläche der Laserdiode geneigt ist, und dass eine Kontaktfläche des stegförmigen Streifens (2) in Kontakt mit der DBR-Mantelschicht (8) die erste geneigte Fläche (7) umfasst.

2. Laserdiode nach Anspruch 1, **dadurch gekennzeichnet, dass** ein Winkel zwischen der ersten geneigten Fläche (7) und einer normalen Richtung einer unteren Fläche des stegförmigen Streifens (2) größer als 0 Grad und kleiner als oder gleich 60 Grad ist.

3. Laserdiode nach Anspruch 1, **dadurch gekennzeichnet, dass** eine Endfläche des Substrats (3) eine zweite geneigte Fläche (9) entlang der Längsrichtung des stegförmigen Streifens (2) umfasst, die sowohl in Bezug auf eine normale Richtung einer oberen Fläche des Substrats (3) als auch in Bezug auf die Emissionsendfläche der Laserdiode geneigt ist, und dass eine Kontaktfläche des Substrats (3), die in Kontakt mit der DBR-Mantelschicht (8) steht, die zweite geneigte Fläche (9) umfasst.

4. Laserdiode nach Anspruch 3, **dadurch gekennzeichnet, dass** ein Winkel zwischen der zweiten geneigten Fläche (9) und einer normalen Richtung einer oberen Fläche des Substrats (3) größer als 0 Grad und kleiner als oder gleich 60 Grad ist.

5. Laserdiode nach Anspruch 3, **dadurch gekennzeichnet, dass** die Kontaktfläche des Substrats (3), die in Kontakt mit der DBR-Mantelschicht (8) steht, ferner eine Seitenfläche des Substrats (3) umfasst, und die zweite geneigte Fläche (9) die Seitenfläche des Substrats (3) und eine untere Fläche des Substrats (3) verbindet.

6. Laserdiode nach Anspruch 1, **dadurch gekennzeichnet, dass** sich die erste geneigten Fläche (7) auf der P-Typ-Schicht (6) befindet.

7. Laserdiode nach Anspruch 1, **dadurch gekennzeichnet, dass** die N-Typ-Schicht (4) eine Metallschicht (41) zur Leitung umfasst.

8. Laserdiode nach Anspruch 1, **dadurch gekennzeichnet, dass** die P-Typ-Schicht (6) eine Metallschicht (62) zur Leitung umfasst.

9. Laserdiode nach Anspruch 1, **dadurch gekennzeichnet, dass** die P-Typ-Schicht (6) ferner eine obere Wellenleiterschicht (61) umfasst.

10. Verfahren zur Herstellung einer Laserdiode, umfassend das epitaktische Aufwachsen einer N-Typ-Schicht (4), einer aktiven Schicht (5) und einer P-Typ-Schicht (6) nacheinander auf einem Substrat (3) und ein Herstellen eines stegförmigen Streifens (2) auf der P-Typ-Schicht (6), **dadurch gekennzeichnet, dass** das Verfahren ferner die Schritte umfasst:
Spalten des stegförmigen Streifens (2) in einer Richtung senkrecht zu einer Länge des stegförmigen Streifens (2), um eine Endfläche des stegförmigen Streifens (2) zu erhalten, die eine erste geneigte Fläche (7) ist, die sowohl in Bezug auf eine normale Richtung einer unteren Fläche des stegförmigen Streifens (2) als auch auf eine Emissionsendfläche der Laserdiode geneigt ist;
Aufwachsen einer seitlich plattierten DBR-Mantelschicht (8), und einer Kontaktfläche des stegförmigen Streifens (2) in Kontakt mit der DBR-Mantelschicht (8), die die erste geneigte Fläche (7) umfasst.

11. Verfahren nach Anspruch 10, **dadurch gekennzeichnet, dass** das Verfahren nach dem Schritt des Erhaltens der ersten geneigten Fläche (7) weiterhin umfasst:
Spalten des Substrats (3) in der Richtung senkrecht zur Länge des stegförmigen Streifens (2), um eine Endfläche des Substrats (3) zu erhalten, die eine zweite geneigte Fläche (9) ist, und eine Kontaktfläche des Substrats (3) in Kontakt mit der DBR-Mantelschicht (8), die die zweite geneigte Fläche (9) umfasst.

12. Verfahren nach Anspruch 10, **dadurch gekennzeichnet, dass** der Schritt des Spaltens des stegförmigen Streifens (2) in der Richtung senkrecht zur Länge des stegförmigen Streifens (2) umfasst:
Herstellen einer V-förmigen Rille, einer bogenförmigen Rille, einer offenen umgekehrten trapezförmigen Rille oder einer Kombination davon auf dem stegförmigen Streifen (2) und Teilen des stegförmigen Streifens (2) vertikal entlang der Mitte der Rille, um die Endfläche des stegförmigen Streifens (2) zu bilden.

13. Verfahren nach Anspruch 11, **dadurch gekennzeichnet, dass** der Schritt des Spaltens des Substrats (3) in der Richtung senkrecht zur Länge des stegförmigen Streifens (2) umfasst:
Herstellen einer V-förmigen Rille, einer bogenförmigen Rille, einer offenen, umgekehrten trapezförmigen Rille oder einer Kombination davon auf dem Substrat (3) und Spalten des Substrats (3) vertikal entlang der Mitte der Rille, um die Endfläche des Substrats (3) zu bilden.

14. Verfahren nach Anspruch 12 oder 13, **dadurch gekennzeichnet, dass** eine Längsrichtung der V-förmigen Rille, der bogenförmigen Rille, der offenen umgekehrten trapezförmigen Rille oder einer Kombination davon senkrecht zur Länge des stegförmigen Streifens (2) verläuft.

15. Verfahren nach Anspruch 11, **dadurch gekennzeichnet, dass** der stegförmige Streifen (2) und das Substrat (3) jeweils durch unterschiedlich geformte Rillen geteilt werden.

## Revendications

1. Diode laser comprenant un substrat (3) et une couche empilée sur le substrat (3), la couche empilée comprenant une couche de type N (4), une couche active (5), une couche de type P (6) avec une bande en forme de crête (2) sur une surface de celle-ci, et une couche de revêtement DBR plaquée latéralement (8), **caractérisé en ce qu'**une surface d'extrémité de la bande en forme de crête (2) le long d'une direction de longueur de la bande en forme de crête (2) est une première surface inclinée (7) qui est inclinée à la fois par rapport à une direction normale d'une surface inférieure de la bande en forme de crête (2) et une surface d'extrémité d'émission de la diode laser, et une surface de contact de la bande en forme de crête (2) en contact avec la couche de revêtement DBR (8) comprend la première surface inclinée (7).

2. La diode laser de la revendication 1, **caractérisée par le fait qu'**un angle entre la première surface inclinée (7) et une direction normale d'une surface inférieure de la bande en forme de crête (2) est supérieur à 0 degré et inférieur ou égal à 60 degrés.

3. La diode laser de la revendication 1, **caractérisée par le fait qu'**une surface d'extrémité du substrat (3) comprend une deuxième surface inclinée (9) le long de la direction de la longueur de la bande en forme de crête (2), qui est inclinée à la fois par rapport à une direction normale d'une surface supérieure du substrat (3) et à la surface d'extrémité d'émission de la diode laser, et qu'une surface de contact du substrat (3) en contact avec la couche de revêtement DBR (8) comprend la deuxième surface inclinée (9).

4. La diode laser de la revendication 3, **caractérisée par le fait qu'**un angle entre la seconde surface inclinée (9) et une direction normale d'une surface supérieure du substrat (3) est supérieur à 0 degré et inférieur ou égal à 60 degrés.

5. La diode laser de la revendication 3, **caractérisée par le fait que** la surface de contact du substrat (3) en contact avec la couche de revêtement DBR (8) comprend en outre une surface latérale du substrat (3), et que la seconde surface inclinée (9) relie la surface latérale du substrat (3) et une surface inférieure du substrat (3).

6. La diode laser de la revendication 1, **caractérisée par le fait que** la première surface inclinée (7) est située sur la couche de type P (6).

7. La diode laser de la revendication 1, **caractérisée par le fait que** la couche de type N (4) comprend une couche métallique (41) pour la conduction.

8. La diode laser de la revendication 1, **caractérisée par le fait que** la couche de type P (6) comprend une couche métallique (62) pour la conduction.

9. La diode laser de la revendication 1, **caractérisée par le fait que** la couche de type P (6) comprend en outre une couche supérieure de guide d'ondes (61).

10. Procédé de fabrication d'une diode laser comprenant la croissance épitaxiale d'une couche de type N (4), d'une couche active (5) et d'une couche de type P (6) en séquence sur un substrat (3), et la réalisation d'une bande en forme de crête (2) sur la couche de type P (6), **caractérisé en ce que** le procédé comprend en outre les étapes suivantes :
diviser la bande en forme de crête (2) dans une direction perpendiculaire à une longueur de la bande en forme de crête (2) pour obtenir une surface d'extrémité de la bande en forme de crête (2) qui est une première surface inclinée (7) inclinée à la fois par rapport à une direction normale d'une surface inférieure de la bande en forme de crête (2) et à une surface d'extrémité d'émission de la diode laser ;
la croissance d'une couche de revêtement DBR plaquée latéralement (8), et une surface de contact de la bande en forme de crête (2) en contact avec la couche de revêtement DBR (8) comprenant la première surface inclinée (7).

11. Le procédé de la revendication 10, **caractérisé en ce que**, après l'étape d'obtention de la première surface inclinée (7), le procédé comprend en outre :
diviser le substrat (3) dans la direction perpendiculaire à la longueur de la bande en forme de crête (2) pour obtenir une surface d'extrémité du substrat (3) qui est une deuxième surface inclinée (9), et une surface de contact du substrat (3) en contact avec la couche de revêtement DBR (8) comprenant la deuxième surface inclinée (9).

12. Procédé de la revendication 10, **caractérisé par le fait que** l'étape de division de la bande en forme de crête (2) dans la direction perpendiculaire à la longueur de la bande en forme de crête (2) comprend :
réaliser une rainure en forme de V, une rainure en forme d'arc, une rainure trapézoïdale inversée ouverte ou une combinaison de celles-ci sur la bande en forme de crête (2) et fendre la bande en forme de crête (2) verticalement le long du milieu de la rainure pour former la surface d'extrémité de la bande en forme de crête (2).

13. Procédé selon la revendication 11, **caractérisé par le fait que** l'étape consistant à fendre le substrat (3) dans la direction perpendiculaire à la longueur de la bande en forme de crête (2) comprend :
réalisation d'une rainure en forme de V, d'une rainure en forme d'arc, d'une rainure trapézoïdale inversée ouverte ou d'une combinaison de celles-ci sur le substrat (3) et division verticale du substrat (3) le long du milieu de la rainure pour former la surface d'extrémité du substrat (3).

14. Procédé selon la revendication 12 ou 13, **caractérisée par le fait qu'**une direction de longueur de la rainure en forme de V, de la rainure en forme d'arc, de la rainure trapézoïdale inversée ouverte ou de leur combinaison est perpendiculaire à la longueur de la bande en forme de crête (2).

15. Procédé selon la revendication 11, **caractérisée par le fait que** la bande en forme de crête (2) et le substrat (3) sont fendus respectivement à l'aide de rainures de forme différente.
